# FASCICULE DE BREVET EUROPEEN

(11) **EP 3 867 093 B1**
(45) Date de publication et mention de la délivrance du brevet: **16.08.2023**
(21) Numéro de dépôt: 19795608.9
(22) Date de dépôt: 25.09.2019
(51) Int. Cl.: B60L 50/20, B60L 58/16, B60L 58/12, B60L 3/12, G01R 31/3828, G01R 31/385, G01R 31/387, G01R 31/392, G01R 31/389

(54) **SYSTÈME DE DIAGNOSTIC SUR PLACE DE LA BATTERIE D'UN VÉLO ÉLECTRIQUE**
SYSTEM ZUR VOR-ORT-DIAGNOSE DER BATTERIE EINES ELEKTRISCHEN FAHRRADES
SYSTEM FOR ON-SITE DIAGNOSIS OF THE BATTERY OF AN ELECTRIC BICYCLE

(30) Priorité: 16.10.2018 FR 1859568
(43) Date de publication de la demande: 25.08.2021
(73) Titulaire: eBikeLabs, 38019 Grenoble Cedex (FR)
(72) Inventeur: BOSSON, Maël, 38000 Grenoble (FR); MARGUET, Raphael, 38100 Grenoble (FR); ALARY, Theophile, 38100 Grenoble (FR)
(74) Mandataire: de Jong, Jean Jacques
(86) Numéro de dépôt international: PCT/FR2019/052261
(87) Numéro de publication internationale: WO 2020/079336

(56) Documents cités:
- EP-A1- 3 127 739
- FR-A1- 2 920 884
- US-A1- 2012 063 900
- US-A1- 2015 134 169

## Description

### Domaine

L'invention est relative aux diagnostics de batteries rechargeables de véhicules électriques, et plus particulièrement à des diagnostics réalisés sur place, c'est-à-dire mis en oeuvre par le dispositif de commande du véhicule sans démonter la batterie.

### Arrière-plan

Les véhicules électriques permettent souvent de réaliser des diagnostics sur place de leurs batteries. Pour cela, ils sont conçus pour surveiller différents paramètres de la batterie au cours d'une utilisation normale du véhicule, notamment au démarrage, à l'arrêt, et/ou au cours de l'utilisation du véhicule. Les paramètres mesurés, généralement la capacité, la résistance interne, et la tension à vide à différents états de charge, servent à estimer un « état de santé » de la batterie, souvent désigné par SOH (« State Of Health »), à l'aide d'une cartographie. Toutefois, les mesures, notamment la capacité, peuvent varier en fonction du profil de décharge de la batterie, de sorte que les estimations de l'état de santé sont variables alors que l'état de santé réel de la batterie ne varie pas.

Pour estimer un état de santé de manière plus reproductible, on préfère effectuer des diagnostics réguliers selon un même profil de décharge fixe, qui est généralement inadapté à un usage normal du véhicule. Idéalement, la batterie est entièrement déchargée pendant le diagnostic selon le profil fixe, pour estimer de manière précise la capacité. Une décharge complète, compte tenu des pertes d'énergie générées, est peu adaptée à des batteries de grande capacité, comme celles utilisées dans les voitures, mais reste raisonnable pour des batteries de vélo électrique.

Pour réaliser un diagnostic sur place selon un profil de décharge fixe, on a proposé d'utiliser le moteur comme charge résistive, par exemple dans le brevet FR2920884. Cependant, ces techniques n'ont pas été appliquées à une décharge complète de la batterie, pouvant durer plusieurs heures.

### Résumé

On prévoit de façon générale un procédé de diagnostic sur place d'une batterie rechargeable de véhicule électrique, comprenant des étapes consistant à décharger la batterie dans un moteur du véhicule, en utilisant la résistance interne du moteur comme charge résistive ; mesurer des paramètres de la batterie en cours de décharge pour établir son état de santé ; estimer la température du moteur en cours de décharge ; et réguler le courant de décharge pour maintenir la température du moteur à un seuil admissible constant.

L'étape de mesure de paramètres peut comprendre des étapes consistant à arrêter la décharge, d'où il résulte que la température du moteur baisse ; lorsque la température du moteur atteint un seuil bas, appliquer une impulsion de courant de décharge élevé, apte à la mesure de la résistance interne de la batterie ; mesurer la résistance interne de la batterie ; et reprendre la décharge.

Le procédé peut comprendre des étapes consistant à déterminer une capacité thermique du moteur ; et déterminer le seuil bas de la température du moteur en fonction de la capacité thermique du moteur, de manière que l'application de l'impulsion de courant de décharge relève la température du moteur vers une valeur proche du seuil admissible.

La détermination de la capacité thermique du moteur peut comprendre les étapes préalables consistant à appliquer au moteur froid une impulsion de courant de décharge, apte à porter la température du moteur près d'une température connue ; laisser refroidir le moteur ; déterminer une constante de temps thermique en fonction du temps mis par le moteur à refroidir d'un écart de température ; déterminer une résistance thermique du moteur à partir de la puissance fournie par la batterie en régime de décharge établi où la température du moteur est au seuil admissible ; et déterminer la capacité thermique à partir de la constante de temps thermique et de la résistance thermique.

Le moteur peut être triphasé, le procédé comprenant alors, pendant l'application d'un courant de décharge, l'étape de connecter deux des trois phases du moteur à une première borne de la batterie, et connecter la phase restante à une deuxième borne de la batterie.

Le moteur peut être commandé par un circuit de commande à flux orienté dont les consignes sont réglées pour produire un courant élevé et un couple faible.

Le véhicule peut être un vélo, les consignes du circuit de commande étant réglées pour produire une rotation dans le sens inverse de la marche du vélo.

### Description sommaire des dessins

Des modes de réalisation seront exposés dans la description suivante, faite à titre non limitatif en relation avec les figures jointes parmi lesquelles :
- la figure 1 représente schématiquement un moteur triphasé de véhicule électrique et une partie de son circuit de commande ;
- la figure 2 est un graphe illustrant un exemple d'évolution de paramètres lors d'une phase initiale d'un procédé de diagnostic selon l'invention ;
- la figure 3 est un graphe illustrant un exemple d'évolution de paramètres lors d'une phase intermédiaire d'un procédé de diagnostic selon l'invention ; et
- la figure 4 est un graphe illustrant un exemple d'évolution de paramètres lors d'une phase préliminaire de mesure d'une constante de temps thermique du moteur.

### Description détaillée

L'utilisation d'un moteur électrique comme charge résistive pour effectuer des diagnostics de batterie présente certaines difficultés lorsque les phases de décharge sont longues, par exemple lorsqu'on souhaite complètement décharger la batterie. En effet, on souhaite généralement raccourcir la phase de décharge en appliquant un courant de décharge le plus élevé possible. Un moteur électrique installé dans son véhicule n'est généralement pas conçu pour subir continûment un courant si élevé pendant la durée relativement longue requise à la décharge. Cette difficulté est exacerbée par le fait que l'on souhaite que le moteur reste immobile, ce qui diminue la ventilation et la capacité du moteur à évacuer la chaleur dissipée par la résistance interne du moteur. En effet, si le moteur tournait librement, il ne pourrait pas tirer le courant souhaité du fait de l'augmentation de la force contre-électromotrice.

On présente ci-après un procédé de diagnostic de batterie permettant une décharge complète de la batterie en utilisant le moteur comme charge résistive dans des conditions n'affectant pas la durée de vie du moteur. Pour fournir un courant de décharge le plus élevé possible dans ces conditions, le procédé de diagnostic est basé sur une boucle de régulation qui tend à stabiliser la température du moteur à une valeur constante admissible sur la durée en ajustant le courant de décharge.

Le courant de décharge de la batterie est ainsi automatiquement adapté aux conditions de refroidissement du moteur - si le moteur est placé dans un local frais et ventilé, le courant de décharge sera plus élevé que lorsque le moteur est placé dans un local chaud. Par ailleurs, comme l'échauffement du moteur, dans des conditions stabilisées, est proportionnel à la puissance qu'il reçoit, il s'avère que la boucle de régulation ajuste le courant pour produire une puissance constante. La tension de batterie décroissant au cours de la décharge, le courant de décharge augmente pour maintenir la puissance et la température constantes.

Un tel profil de décharge est inhabituel dans des diagnostics classiques, qui utilisent plutôt un courant constant. Cela n'a aucune importance en pratique, car on ne cherche pas à comparer des résultats de différentes méthodes de diagnostic, mais l'évolution des résultats d'une même méthode de diagnostic appliquée à des intervalles réguliers sur la batterie.

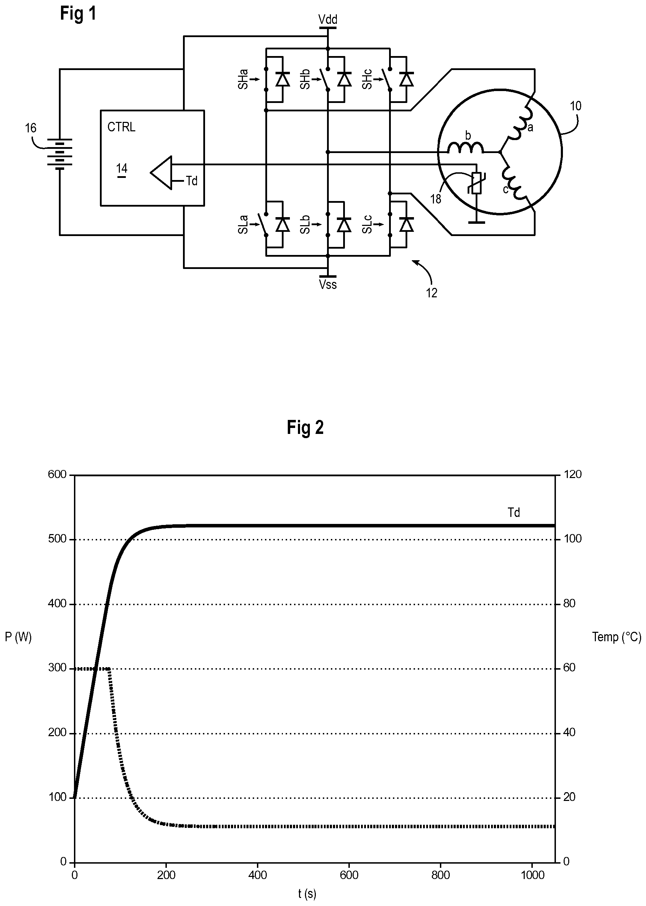

La figure 1 illustre schématiquement une configuration matérielle utilisable pour mettre en oeuvre le procédé. Un moteur triphasé 10 d'un vélo électrique est associé avec un dispositif de commande dont on a seulement représenté des éléments servant à comprendre le procédé. Les bobinages ou phases a, b, c, du moteur peuvent être disposés en étoile, comme cela est représenté. Le dispositif de commande peut être de type classique, par exemple à champ orienté, dit FOC.

Le dispositif de commande comprend un étage de puissance 12, généralement des commutateurs électroniques formant un « pont en H ». Chaque phase du moteur est commandée par une paire de commutateurs SH, SL, le premier commutateur reliant la phase à une ligne d'alimentation haute Vdd, et le second reliant la phase à une ligne d'alimentation basse Vss. Les commutateurs associés à une phase sont suffixés par le nom de la phase. Chaque commutateur est en outre muni d'une diode de roue libre, ces diodes assurant une évacuation de courants induits vers une ligne d'alimentation même si les commutateurs sont ouverts.

Un circuit de commande 14 est configuré pour gérer le moteur par l'intermédiaire de l'étage de puissance 12 en fonction de mesures de capteurs et de consignes. Ces éléments sont bien connus de l'homme du métier et ne seront pas décrits plus en détail.

Une batterie rechargeable 16 alimente les différents éléments du dispositif de commande par les lignes Vdd et Vss.

Pour mettre en oeuvre le procédé, on utilise un retour en température du moteur. Pour cela, le moteur est, par exemple, muni d'un capteur de température 18 exploité par le circuit de commande 14. Un tel capteur est souvent présent dans des systèmes de commande classiques, pour limiter le courant lorsque la température du moteur, en fonctionnement normal, excède un seuil. Dans certains systèmes sans capteur de température, la température peut être estimée par une mesure de la résistance interne des bobinages du moteur, qui varie en fonction de la température. La température estimée ou fournie par le capteur 18 peut être comparée dans le circuit de commande, comme cela est illustré, à une consigne de température de diagnostic Td pour, dans un mode de diagnostic, ajuster le courant en vue de faire tendre la température du moteur vers cette consigne. La consigne Td est choisie aussi élevée que possible tout en veillant à ce que la durée de vie du moteur ne soit pas affectée après plusieurs heures de fonctionnement à cette température.

Le circuit de commande 14 peut être programmé pour mettre en oeuvre le procédé de diagnostic à la demande de l'utilisateur. Dans un mode de diagnostic, le circuit 14 commande le moteur de façon générale pour maximiser le courant et minimiser le couple, en fait de manière à obtenir un rendement quasi nul. Pour cela deux phases du moteur 10 peuvent être alimentées en permanence, par exemple les phases *a* et *b* en fermant les commutateurs SHa et SLb. Les résistances internes des bobinages *a* et *b* sont alors connectées en série entre les bornes de la batterie 16, et servent de charge résistive pour décharger la batterie.

De préférence, la phase restante *c* est aussi connectée à l'une des bornes de la batterie, par exemple à la borne Vss par le commutateur SLc. Cela diminue la valeur résultante de la charge résistive et répartit le courant de décharge sur les trois phases, offrant une meilleure dissipation thermique. De plus cette connexion des trois phases provoque deux couples antagonistes qui rendent le moteur moins apte à tourner, ce qui peut être un effet recherché.

Cette méthode de connexion des phases, présentée à titre illustratif, est en fait difficile à mettre en oeuvre dans le cadre d'une utilisation normale d'un circuit de commande classique. Selon une alternative, on peut utiliser des consignes disponibles dans un circuit de commande à flux orienté classique. On peut notamment agir sur une consigne de flux pour fixer le courant à un seuil élevé, sur une consigne de couple pour tendre à annuler le couple, et sur une consigne de position (ou de vitesse de rotation) pour annuler ou ralentir la rotation du moteur. Les deux derniers paramètres sont liés, de sorte que si on fixe un couple nul, le moteur restera dans une position fixe. De même, si on fixe la position, le couple devient nul lorsque la position est atteinte. Dans ces configurations les courants ne sont pas équitablement répartis sur les trois phases.

La figure 2 est un graphe illustrant un exemple d'évolution de la puissance P fournie au moteur (en trait discontinu) et de la température Temp du moteur (en trait plein) au cours du temps t, au démarrage d'une phase de décharge du mode de diagnostic. A titre d'exemple, le moteur est un moteur moyeu de 250 W placé dans un local à 20°C et la batterie a une capacité de 500 W.h.

La phase de diagnostic peut commencer par un intervalle où le système de régulation est « en butée » pour tenir compte des contraintes classiques du système (courant moteur maximum et courant batterie maximum). Les résistances internes des phases du moteur étant faibles, de l'ordre de 0,1 Ohm, le courant tiré sur la batterie dépasserait tout seuil toléré lorsque le moteur est à l'arrêt. Ainsi, le système commence par limiter le courant de décharge en opérant un hachage à l'aide des commutateurs, le courant résultant étant lissé grâce aux inductances internes des bobinages. Dans l'exemple, le système peut être conçu pour hacher le courant de sorte à limiter la puissance à 300 W.

Dès lors, la température du moteur croît rapidement depuis 20°C. Après environ 80 s, la température atteint 85°C. Le système de régulation n'est plus en butée et applique, par exemple, une régulation proportionnelle et intégrale (PI). Au fur et à mesure que la température continue à croître à partir de 85°C, le courant de décharge et la puissance diminuent pour ralentir l'évolution de la température. A partir de 200 s, la température atteint la consigne Td, et la puissance se stabilise. A titre d'exemple, Td vaut environ 105°C, et la puissance se stabilise à environ 50 W.

Lors d'une phase de décharge complète selon des méthodes de diagnostic classiques, on effectue généralement au moins une mesure de la résistance interne de la batterie. Une telle mesure consiste à appliquer une impulsion de courant de décharge de caractéristiques connues et à calculer la résistance à partir du différentiel de courant et du différentiel des tensions mesurées avant et après le front descendant de l'impulsion de courant. L'impulsion de courant a une durée préconisée d'au moins 10 s et son intensité est aussi élevée que possible, car la précision de la mesure est d'autant meilleure que l'intensité est élevée.

Il est difficile d'envisager cette méthode de mesure directement dans la phase de décharge de la figure 2. En effet, l'impulsion de courant de décharge provoquerait un échauffement du moteur au-delà du seuil admissible Td.

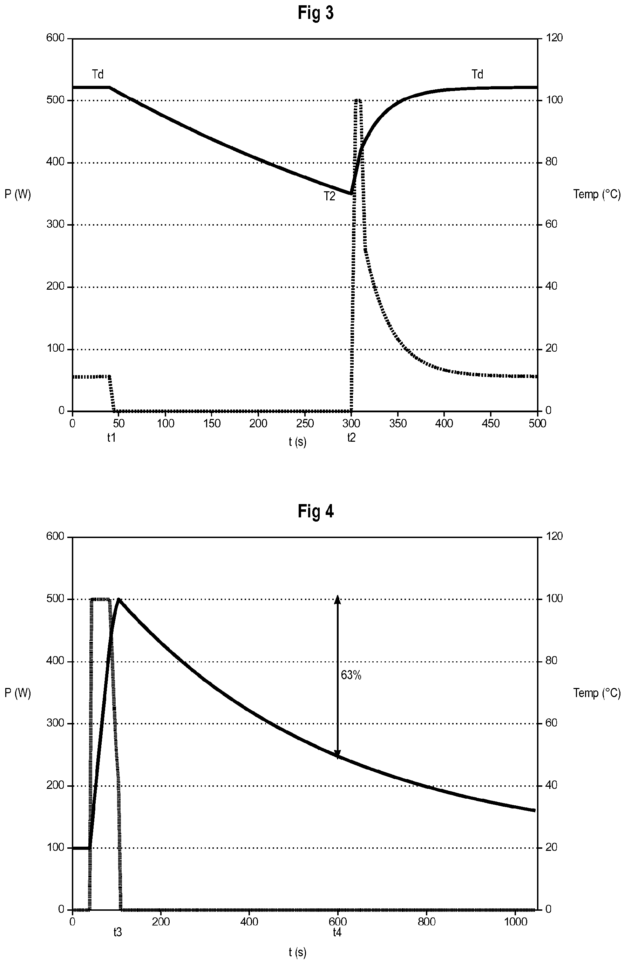

La figure 3 est un graphe illustrant un exemple d'évolution de la puissance (en trait discontinu) et de la température (en trait plein) du moteur lors d'une phase de mesure de résistance interne adaptée au présent procédé.

Après un démarrage de la phase de décharge selon la figure 2, le moteur ayant atteint la température Td, le courant de déchargé est interrompu à un instant t1. La température du moteur décroît alors.

A un instant t2, ici environ 250 s plus tard, la température atteint un seuil bas T2 laissant suffisamment de marge d'échauffement au moteur pour supporter une impulsion de courant de mesure de forte intensité. La température T2 ou le différentiel Td-T2 peut être une consigne programmée et détectée par le circuit de commande 14 en mesurant la température.

Ainsi, à partir de l'instant t2, le système applique une impulsion de courant de décharge de forte intensité qui dure environ 10 s. L'intensité est aux limites de ce que peut produire le système, ici telle que la puissance atteint 500 W, et permet une mesure relativement précise de la résistance interne de la batterie selon les méthodes classiques.

L'impulsion provoque une élévation rapide de la température du moteur. La température T2 est choisie pour que la température du moteur approche la température Td, mais ne la dépasse pas, compte tenu de l'énergie connue de l'impulsion.

A la fin de l'impulsion, la phase de décharge normale reprend - la régulation prend le relais et fait tendre la température vers le seuil Td.

Une difficulté de cette méthode de mesure réside dans le choix du différentiel Td-T2. En effet, le différentiel devrait être suffisamment grand pour que l'impulsion de courant, de caractéristiques fixées, n'échauffe pas le moteur au-dessus de la température Td. Cette élévation de température du moteur, pour une même impulsion de courant, dépend de la capacité thermique du moteur, qui est fonction de la structure du moteur. Bien entendu, on peut choisir le différentiel Td-T2 avec une marge couvrant toutes les conditions envisageables, mais cela allonge le diagnostic dans le cas général, notamment si on envisage d'effectuer des mesures répétées de la résistance interne de la batterie.

La figure 4 est un graphe illustrant un exemple d'évolution de la puissance et de la température lors d'une étape préliminaire d'estimation de la capacité thermique du moteur. Cette étape de mesure, visant à déterminer la constante thermique du moteur au refroidissement, est effectuée de préférence juste avant la phase de diagnostic, de sorte à refléter le mieux possible les conditions du moteur pendant le diagnostic. Le circuit de commande 14 peut être programmé pour précéder chaque diagnostic systématiquement par cette étape de mesure.

Le moteur étant à température ambiante avant la phase de diagnostic, on cherche à échauffer le moteur vers une température élevée admissible connue, 100°C dans cet exemple. On applique par exemple une impulsion de décharge de 500 W. A la fin de l'impulsion, à un instant t3, le courant est annulé, et on laisse refroidir le moteur. On relève le temps t4-t3 mis par le moteur à abaisser sa température de 63 % du différentiel entre la température atteinte et la température ambiante. Le différentiel étant de 80°C dans l'exemple, on relève le temps mis par le moteur pour passer de 100 à 50°C, à savoir de l'ordre de 500 s ici - cette valeur est la constante de temps thermique τ, égale à RC, où R est la résistance thermique du moteur avec son milieu ambiant, et C est la capacité thermique du moteur.

Lors de la phase de décharge suivante, selon la figure 2, on obtient un régime établi avec un différentiel de température (105-20 = 85°C) et une puissance électrique qui maintient ce différentiel (50W), équivalente à la puissance dissipée par le moteur dans son milieu ambiant. On déduit ainsi la résistance thermique R = 85/50 = 1,7 K/W. De la valeur trouvée précédemment pour la constante de temps thermique, on trouve C = τ/R = 500/1,7 = 294 J/K. Le différentiel Td-T2 requis est ainsi choisi supérieur à E/C, où E est l'énergie de l'impulsion de mesure.

On remarquera que la phase de mesure de la résistance interne (figure 3) peut servir à mesurer d'autres paramètres servant à estimer un état de santé, comme la tension à vide de la batterie. Cette valeur de tension est généralement mesurée en annulant momentanément le courant de décharge. Ainsi, cette valeur de tension peut être relevée dans la figure 3 dès l'instant t1.

Un autre paramètre est la capacité de la batterie. Lorsque le courant de décharge est constant, il suffit de multiplier la valeur du courant par le temps de décharge. Dans le cas présent, le courant augmente au fur et à mesure que la batterie se décharge, et des phases de mesure de la résistance interne viennent perturber la constance de la décharge - on utilise alors une technique de « compteur de coulombs », qui tient compte des variations du courant de décharge, et également de la décharge produite par une éventuelle étape de mesure de la constante de temps thermique (figure 4).

Le procédé de diagnostic décrit s'applique à tout véhicule électrique, mais est principalement destiné aux vélos électriques ou autres petits véhicules électriques, dont les batteries ont une capacité suffisamment faible pour qu'il soit raisonnable de les décharger complètement pendant le diagnostic, solution qui fournit les estimations les plus fiables.

Dans ce qui précède, pour utiliser les bobinages du moteur comme charge résistive, on a évoqué un mode de commande statique qui tend à produire un courant de décharge élevé sans produire de rotation du moteur, en fait un mode de commande que l'on souhaite éviter en fonctionnement normal, car produisant un rendement quasi nul. Dans une telle configuration, il s'avère que l'un des bobinages dissipe la moitié de la puissance totale alors que les deux autres se partagent de manière non nécessairement équitable la moitié restante.

Pour répartir le courant de manière plus homogène sur les trois bobinages, et ainsi potentiellement augmenter le courant de décharge, on peut programmer le circuit de commande 14 pour appliquer des consignes tendant à faire tourner le moteur.

La batterie diagnostiquée étant notamment celle d'un vélo, il peut être gênant que la roue tende à tourner, car un vélo ne dispose pas de frein de garage ni d'embrayage ou autre dispositif de désaccouplement du moteur.

Pour limiter le déplacement du vélo, la commande peut être soit configurée pour que la répartition des courants ne soit pas parfaitement équitable, soit pour que la fréquence de variation soit très élevée. Cette deuxième solution provoquerait une vibration du vélo, mais pas de déplacement intempestif, mais pourrait engendrer des dommages sur le moteur.

Dans certaines conditions, on peut cependant permettre au moteur de tourner. Cela favorise sa dissipation thermique et est parfaitement envisageable dans un moteur muni d'une roue libre, auquel cas la commande fait tourner le moteur dans le sens inverse de la marche. En principe, lorsque le moteur est libre de tourner sans charge, il a tendance à consommer peu de courant, la consommation de courant augmentant généralement avec le couple résistant. Par contre, en utilisant une commande à flux orienté, on peut imposer une consigne de flux, donc un courant, de manière à augmenter la consommation de courant du moteur sans augmenter sa vitesse de rotation.

Cela est également envisageable, même avec un moteur sans roue libre, lorsque l'utilisateur s'assure de toujours garer le vélo avec la roue motrice relevée et sans entrave, de sorte que la roue puisse tourner librement.

## Revendications

1. Procédé de diagnostic sur place d'une batterie rechargeable de véhicule électrique, comprenant les étapes suivantes :
décharger la batterie (16) dans un moteur (10) du véhicule, en utilisant la résistance interne du moteur comme charge résistive ; et
mesurer des paramètres de la batterie en cours de décharge pour établir son état de santé ;
**caractérisé en ce qu'**il comprend les étapes suivantes :
estimer (18) la température du moteur en cours de décharge ; et
réguler le courant de décharge pour stabiliser la température du moteur à un seuil admissible constant (Td).

2. Procédé selon la revendication 1, dans lequel l'étape de mesure de paramètres comprend les étapes suivantes :
arrêter la décharge (11), d'où il résulte que la température du moteur baisse ;
lorsque la température du moteur atteint un seuil bas (T2), appliquer (t2) une impulsion de courant de décharge élevé, apte à la mesure de la résistance interne de la batterie ;
mesurer la résistance interne de la batterie ; et
reprendre la décharge.

3. Procédé selon la revendication 2, comprenant les étapes suivantes :
déterminer une capacité thermique du moteur ; et
déterminer le seuil bas (T2) de la température du moteur en fonction de la capacité thermique du moteur, de manière que l'application de l'impulsion de courant de décharge relève la température du moteur vers une valeur proche du seuil admissible (Td).

4. Procédé selon la revendication 3, dans lequel la détermination de la capacité thermique du moteur comprend les étapes préalables suivantes :
appliquer au moteur froid une impulsion de courant de décharge, apte à porter la température du moteur près d'une température connue ;
laisser refroidir le moteur ;
déterminer une constante de temps thermique en fonction du temps mis par le moteur à refroidir d'un écart de température ;
déterminer une résistance thermique du moteur à partir de la puissance fournie par la batterie en régime de décharge établi où la température du moteur est au seuil admissible ; et
déterminer la capacité thermique à partir de la constante de temps thermique et de la résistance thermique.

5. Procédé selon la revendication 1, dans lequel le moteur est triphasé, et le procédé comprend, pendant l'application d'un courant de décharge, l'étape de connecter deux (b, c) des trois phases du moteur à une première borne de la batterie, et connecter la phase restante (a) à une deuxième borne de la batterie.

6. Procédé selon la revendication 1, dans lequel le moteur est commandé par un circuit de commande à flux orienté dont les consignes sont réglées pour produire un courant élevé et un couple faible.

7. Procédé selon la revendication 6, dans lequel le véhicule est un vélo et les consignes du circuit de commande sont réglées pour produire une rotation dans le sens inverse de la marche du vélo.

## Patentansprüche

1. Verfahren für eine Vor-Ort-Diagnose einer wiederaufladbaren Batterie eines elektrischen Fahrzeugs, umfassend die folgenden Schritte:
Entladen der Batterie (16) in einem Motor (10) des Fahrzeugs, unter Verwendung des internen Widerstands des Motors als ohmsche Belastung; und
Messen der Parameter der Batterie während der Entladung, um ihren Intaktheitsstatus festzulegen;
**dadurch gekennzeichnet, dass** es die folgenden Schritte umfasst:
Schätzen (18) der Temperatur des Motors während der Entladung; und
Regulieren des Entladestroms, um die Temperatur des Motors auf einen konstanten zulässigen Schwellenwert (Td) zu stabilisieren.

2. Verfahren nach Anspruch 1, wobei der Schritt des Messens der Parameter die folgenden Schritte umfasst:
Unterbrechen der Entladung (t1), woraus sich ergibt, dass sich die Temperatur des Motors senkt;
wenn die Temperatur des Motors einen unteren Schwellenwert (T2) erreicht, Anwenden (t2) eines erhöhten Entladestromimpulses, der geeignet ist, den internen Widerstand der Batterie zu messen;
Messen des internen Widerstands der Batterie; und
Fortsetzen der Entladung.

3. Verfahren nach Anspruch 2, umfassend die folgenden Schritte:
Bestimmen einer Wärmekapazität des Motors; und
Bestimmen des unteren Schwellenwerts (T2) der Temperatur des Motors in Abhängigkeit von der Wärmekapazität des Motors, so dass das Anwenden des Entladestromimpulses die Temperatur des Motors auf einen Wert nahe dem zulässigen Schwellenwert (Td) anhebt.

4. Verfahren nach Anspruch 3, wobei das Bestimmen der Wärmekapazität des Motors die folgenden vorgängigen Schritte umfasst:
Anwenden eines Entladestromimpulses auf einen kalten Motor, der geeignet ist, die Temperatur des Motors nahe einer bekannten Temperatur zu bringen;
Abkühlenlassen des Motors;
Bestimmen einer thermischen Zeitkonstante in Abhängigkeit der Zeit, die durch den Motor benötigt wird, um sich von einer Temperaturabweichung abzukühlen;
Bestimmen eines thermischen Widerstands des Motors durch die Leistungsabgabe der Batterie bei einem festgelegten Betrieb der Entladung, bei dem die Temperatur des Motors bei dem zulässigen Schwellenwert liegt; und
Bestimmen der Wärmekapazität des Motors durch die thermische Zeitkonstante und den thermischen Widerstand.

5. Verfahren nach Anspruch 1, wobei der Motor dreiphasig ist, und wobei das Verfahren während der Anwendung eines Entladestroms den Schritt des Verbindens von zwei (b, c) der drei Phasen des Motors mit einem ersten Anschluss der Batterie und Verbinden der verbleibenden Phase (a) mit einem zweiten Anschluss der Batterie umfasst.

6. Verfahren nach Anspruch 1, wobei der Motor durch eine flussorientierte Steuerschaltung gesteuert wird, dessen Vorgaben eingestellt sind, um einen erhöhten Strom und ein niedriges Drehmoment zu erzeugen.

7. Verfahren nach Anspruch 6, wobei das Fahrzeug ein Fahrrad ist und die Vorgaben der Steuerschaltung eingestellt sind, um eine Drehung entgegengesetzt der Fahrtrichtung des Fahrrads zu erzeugen.

## Claims

1. A method for in-place diagnosis of a rechargeable electric vehicle battery, comprising the following steps:
discharging the battery (16) in a motor (10) of the vehicle, using an internal resistance of the motor as a resistive load; and
measuring parameters of the battery during discharge to establish its state of health;
**characterized in that** it comprises the following steps:
estimating (18) the temperature of the motor during discharge; and
regulating the discharge current to stabilize the temperature of the motor at a constant admissible threshold (Td).

2. The method of claim 1, wherein the parameter measurement step comprises the following steps:
stopping the discharge (t1), whereby the motor temperature drops;
when the motor temperature reaches a low threshold (Td), applying (t2) a high discharge current pulse, suitable for measuring the internal resistance of the battery;
measuring the internal resistance of the battery; and
resuming discharging.

3. The method of claim 2, comprising the following steps:
determining a heat capacity of the motor; and
determining the low threshold (T2) of the motor temperature based on the thermal capacity of the motor, so that the application of the discharge current pulse raises the motor temperature to a value close to the admissible threshold (Td).

4. The method of claim 3, wherein determining the heat capacity of the motor comprises the following prior steps:
applying to the cold motor a discharge current pulse, able to bring the motor temperature close to a known temperature;
allowing the motor to cool down;
determining a thermal time constant based on the time taken by the motor to cool by a temperature difference;
determining a thermal resistance of the engine from the power supplied by the battery in steady state discharging conditions where the motor temperature is at the permissible threshold; and
determining the heat capacity from the thermal time constant and the thermal resistance.

5. The method according to claim 1, wherein the motor is a three-phase motor, and the method comprises, during the application of a discharge current, the step of connecting two (b,c) of the three phases of the motor to a first terminal of the battery, and connecting the remaining phase (a) to a second terminal of the battery.

6. The method of claim 1, wherein the motor is controlled by a field-oriented control circuit whose setpoints are adjusted to produce a high current and a low torque.

7. The method of claim 6, wherein the vehicle is a bicycle and the control circuit setpoints are adjusted to produce rotation opposite a direction of travel of the bicycle.
